# EUROPEAN PATENT SPECIFICATION

(11) **EP 4 618 131 B1**
(45) Date of publication and mention of the grant of the patent: **03.06.2026**
(21) Application number: 24163606.7
(22) Date of filing: 14.03.2024
(51) Int. Cl.: H01J 37/34, C23C 14/34

(54) **METHOD AND APPARATUS FOR DEPOSITING A MATERIAL LAYER**
VERFAHREN UND VORRICHTUNG ZUM ABSCHEIDEN EINER MATERIALSCHICHT
PROCÉDÉ ET APPAREIL POUR DÉPOSER UNE COUCHE DE MATÉRIAU

(43) Date of publication of application: 17.09.2025
(73) Proprietor: Eidgenössische Materialprüfungs- und Forschungsanstalt, 8600 Dübendorf (CH)
(72) Inventor: SIOL, Sebastian, 8052 Zürich (CH); PATIDAR, Jyotish, 8305 Dietlikon (CH)
(74) Representative: Keller Schneider Patent- und Markenanwälte AG

(56) References cited:
- EP-A1- 2 784 799
- FERNANDEZ-MARTINEZ IVAN ET AL: "Room-temperature sputter deposition of gold-colored TiN assisted by niobium bombardment from a bipolar HiPIMS source", JOURNAL OF VACUUM SCIENCE, AMERICAN INSTITUTE OF PHYSICS, 2 HUNTINGTON QUADRANGLE, MELVILLE, NY 11747, vol. 42, no. 2, 14 February 2024 (2024-02-14), XP012286601, ISSN: 0734-2101, [retrieved on 20240214], DOI: 10.1116/6.0003325
- JYOTISH PATIDAR ET AL: "Improving the crystallinity and texture of oblique-angle-deposited AlN thin films using reactive synchronized HiPIMS", ARXIV.ORG, CORNELL UNIVERSITY LIBRARY, 201 OLIN LIBRARY CORNELL UNIVERSITY ITHACA, NY 14853, 26 January 2023 (2023-01-26), XP091421780
- GRECZYNSKI G ET AL: "Control of the metal/gas ion ratio incident at the substrate plane during high-power impulse magnetron sputtering of transition metals in Ar", THIN SOLID FILMS, vol. 642, 14 September 2017 (2017-09-14), pages 36 - 40, XP085238214, ISSN: 0040-6090, DOI: 10.1016/J.TSF.2017.09.027

## Description

### Technical Field

The invention relates to a method for depositing a material layer of a material to be deposited on a substrate by pulsed magnetron sputtering, in particular high-power impulse magnetron sputtering, wherein a predetermined partial pressure of a process gas is maintained in a deposition chamber, wherein the substrate is arranged in the deposition chamber, at least one sputter source is arranged in the deposition chamber, wherein the at least one sputter source including a sputter target being made of at least one chemical element of the material to be deposited and wherein voltage pulses are applied with at least one voltage source to the at least one sputter source for generating a plasma from the process gas in order to sputter atoms, in particular ionised atoms, of target material off the sputter target of the respective one of the at least one sputter source for depositing the respective atoms on the substrate for depositing the material layer on the substrate. Furthermore, the invention relates to a deposition apparatus for depositing a material layer of a material to be deposited on a substrate by pulsed magnetron sputtering, in particular high-power impulse magnetron sputtering, with the method according to the invention.

### Background Art

Methods and apparatuses pertaining to the technical field initially mentioned are known. Pulsed Sputter Processes such as High-Power Impulse Magnetron Sputtering (HiPIMS) are emerging thin film and thus material layer deposition techniques with great potential for many applications. As described in the Article "Tutorial: Reactive high power impulse magnetron sputtering (R-HiPIMS)" of André Anders in the Journal of Applied Physics, Volume 121, 171101, of 2017, in these techniques, a high voltage is applied in short pulses in the µs-range to the sputter source. This results in very high peak current densities and plasma densities, which, in turn, leads to an ionization of the sputtered material. This offers unique opportunities to manipulate the kinetic energy of the ions through the application of electric and/or magnetic fields. Specifically the kinetic energy of the positively charged ions can be increased by applying negative potentials on the substrate. The higher kinetic energy leads to increased adatom mobility and momentum transfer onto the growing material layer. This typically results in compact material layers of high crystallinity, even at low substrate temperatures. One downside of the process is, that along with the material layer-forming ions also the positively charged process-gas ions (typically Argon, Ar⁺) are accelerated onto the film. This can lead to the formation of point-defects and undesirable amounts of compressive stress in the deposited material layer.

During a pulsed HiPIMS discharge, a phenomenon called gas rarefaction takes place. According to this phenomenon, process gas ions, e.g. Argon ions, are pushed away to the substrate by the atoms sputtered from the sputter target of the sputter source. Consequently, the process gas ions arrive earlier at the substrate than the ions of the material to be deposited for depositing the material layer. In addition, a time-of-flight difference is observed depending on the atomic mass of the ions, i.e. light elements arrive sooner and heavy elements arrive later. This effect can be utlilized by synchronizing a negative substrate bias pulse to the HiPIMS pulse, which can facilitate the preferential acceleration of specific ionic species. As described in the publication *"*Pardigm shift in thin-film growth by magnetron sputtering. From gas-ion to metal-ion irradiation of the growing film" by Grzegorz Greczynski et al in the Journal of Vacuum Science & Technology A, Volume 37, 060801 of 2019, it has been shown that by preferentially accelerating the metal ions, superior film properties can be achieved. In particular, the process gas incorporation and stress state can be reduced significantly, when compared to material layers which are deposited using a constant negative substrate bias.

One major unsolved challenge is how to apply those kind of negative substrate bias potentials on insulating substrates or during the growth of thick dielectric material layers. In the case of such insulating substrates, no substrate bias potential can be applied to the substrate itself. Instead, the electronic potential on the substrates' surface is floating and will equilibrate with the plasma potential in the deposition chamber. The same applies if a substrate is electronically floating, i.e. if the substrate holder is not electronically connected. The latter is the case in many commercial sputter systems. Publication "Room-temperature sputter deposition of gold-colored TiN assisted by niobium bombardment from a bipolar HiPIMS source" by Fernandez-Martinez et al (2024) in JVST A, 42(2), pages 023107-1 to 023107-11 discloses an apparatus for depositing gold-colored TiN films without applying substrate heating.The energetic impact of Nb¹⁺ ions during the deposition of TiN is achieved within a bipolar high-power impulse magnetron sputtering discharge operating on a Nb target. A separate Ti target is operated with DC magnetron sputtering. Momentum is transferred from the Nb¹⁺ ions to the Ti neutrals in the plasma, whereby Nb-doped TiN films may be formed without biasing or heating the substrate.

Documents "Improving the crystallinity and texture of oblique-angle-deposited AIN thin films using reactive synchronized HiPIMS" by Patidar et al (2023) in Surface and Coatings Technology, 468, 129719, "Control of the metal/gas ion ratio incident at the substrate plane during high-power impulse magnetron sputtering of transition metals in Ar" by Greczynski et al (2017) in Thin solid films, 642, pages 36-40 and EP2784799A1 all relate to synchronizing a negative substrate bias pulse to the HIPIMS pulse, whereby specific ionic species may be preferentially accelerated.

### Summary of the invention

It is the object of the invention to create a method for depositing a material layer of a material to be deposited on a substrate by pulsed magnetron sputtering, in particular high-power impulse magnetron sputtering, pertaining to the technical field initially mentioned, that enables the deposition of a material layer with improved properties like for example a lower defect concentration, an improved crystallinity and a reduced residual compressive stress and also enables the deposition of a material layer with an material layer with improved properties at a comparably lower deposition temperature. Furthermore, it is the object of the invention to create a deposition apparatus for depositing a material layer of a material to be deposited on a substrate by pulsed magnetron sputtering, in particular high-power impulse magnetron sputtering, with the method according to the invention.

The solution of the invention is specified by the features of claim 1. According to the invention, the voltage pulses applied to a synchronisable one of the at least one sputter source are applied to the synchronisable one of the at least one sputter source delayed by an offset in time as compared to the voltage pulses applied to a key one of the at least one sputter source. Thereby, the offset in time corresponds to a time the atoms, in particular ionised atoms, of the sputter target of the key one of the at least one sputter source require to reach from the sputter target of the key one of the at least one sputter source to the substrate after a voltage pulse is applied to the key one of the at least one sputter source for generating the plasma from the process gas in order to sputter atoms, in particular ionised atoms, of the target material off the sputter target of the key one of the at least one sputter source. Furthermore, the offset in time is longer than a majority of ions of the process gas require to reach from the plasma in a vicinity of the key one of the at least one sputter source to the substrate after a voltage pulse is applied to the key one of the at least one sputter source for generating the plasma from the process gas in order to sputter atoms, in particular ionised atoms, of the target material off the sputter target of the key one of the at least one sputter source.

Furthermore, the solution of the invention includes a deposition apparatus for depositing a material layer of a material to be deposited on a substrate by pulsed magnetron sputtering, in particular high-power impulse magnetron sputtering, with the method according to the invention. The deposition apparatus includes a deposition chamber for containing a process gas at a predetermined partial pressure, at least one sputter source, in particular at least two sputter sources, each one of the at least one sputter source including a sputter target being made of at least one chemical element of the material to be deposited on the substrate, and at least one voltage source for applying voltage pulses to the at least one sputter source for generating a plasma from the process gas when the deposition chamber contains the predetermined partial pressure of the process gas in order to sputter atoms, in particular ionised atoms, of target material off the sputter target of the respective one of the at least one sputter source for depositing the respective atoms on the substrate for depositing the material layer on the substrate. Furthermore, the deposition apparatus includes a control module adapted to control the at least one voltage source to apply to a synchronisable one of the at least one sputter source the voltage pulses delayed by an offset in time as compared to the voltage pulses applied to a key one of the at least one sputter source. The offset in time corresponds to a time the atoms, in particular ionised atoms, of the sputter target of the key one of the at least one sputter source require to reach from the sputter target of the key one of the at least one sputter source to the substrate after a voltage pulse is applied to the key one of the at least one sputter source for generating the plasma from the process gas in order to sputter atoms, in particular ionised atoms, of the target material off the sputter target of the key one of the at least one sputter source. Furthermore, the offset in time is longer than a majority of ions of the process gas require to reach from the plasma in the vicinity of the key one of the at least one sputter source to the substrate after a voltage pulse is applied to the key one of the at least one sputter source for generating the plasma from the process gas in order to sputter atoms, in particular ionised atoms, of the target material off the sputter target of the key one of the at least one sputter source.

According to the invention, the at least one sputter source includes a sputter target being made of at least one chemical element of the material to be deposited. Thus, the target material of the sputter target is made of this at least one chemical element.

As mentioned, the deposition apparatus according to the invention includes a control module adapted to control the at least one voltage source to apply to the synchronisable one of the at least one sputter source the voltage pulses delayed by the offset in time as compared to the voltage pulses applied to a key one of the at least one sputter source. This control unit can be a physical control unit like a controller or can by a software running on a computer.

According to the invention, the offset in time corresponds to a time the atoms, in particular ionised atoms, of the sputter target of the key one of the at least one sputter source require to reach from the sputter target of the key one of the at least one sputter source to the substrate after a voltage pulse is applied to the key one of the at least one sputter source for generating the plasma from the process gas in order to sputter atoms, in particular ionised atoms, of the target material off the sputter target of the key one of the at least one sputter source.

The synchronisable one of the at least one sputter source and the key one of the at least one sputter source can be the same sputter source or can be different sputter sources. In case the synchronisable one of the at least one sputter source and the key one of the at least one sputter source are the same sputter source, the offset in time is the repetition rate at which the voltage pulses are applied to this one sputter source.

Advantageously, the process gas is Argon or Nitrogen. Independent of whether the process gas is Argon or Nitrogen, a reactive gas may be inserted into the deposition chamber during deposition of the material layer. Such a reactive gas may for example be oxygen. In case the process gas is Argon, Nitrogen or Oxygen may be inserted into the deposition chamber during deposition of the material layer as reactive gas. In case the process gas is Nitrogen, Oxygen may be inserted into the deposition chamber during deposition of the material layer as reactive gas. The method may however as well be executed without inserting any reactive gas into the deposition chamber during deposition of the material layer.

Advantageously, the at least one sputter source is arranged in the deposition chamber.

Advantageously, the at least one sputter source is a magnetron sputter source.

Advantageously, the substrate is mounted electronically floating in the deposition chamber.

Furthermore, the solution of the invention includes a method for generating a tuning data set for the deposition apparatus for depositing a material layer of a material to be deposited on a substrate by pulsed magnetron sputtering, in particular high-power impulse magnetron sputtering, in order to enable depositing the material layer of the material to be deposited on the substrate with the deposition apparatus with the method according to the invention**.**

Thereby, the deposition apparatus includes a deposition chamber. Advantageously, the deposition apparatus is an apparatus according to the invention. However, the deposition apparatus may as well be any deposition apparatus for depositing a material layer of a material to be deposited on a substrate by pulsed magnetron sputtering, in particular high-power impulse magnetron sputtering, the deposition apparatus including a deposition chamber. In the method for generating the tuning data set, at least one reference sputter source is arranged inside a reference deposition chamber of a reference apparatus of the same type as the deposition chamber of the deposition apparatus, the at least one reference sputter source including a reference sputter target being made of at least one chemical element of the material potentially to be deposited on a substrate with the deposition apparatus. In the method for generating the tuning data set, a predetermined partial pressure of a process gas is maintained in the reference deposition chamber. This predetermined partial pressure of the process gas is advantageously the same partial pressure of the same process gas which is used when effectively depositing a material layer of the material potentially to be deposited on a substrate with the deposition apparatus. In the method for generating the tuning data set, voltage pulses are applied with at least one reference voltage source to the at least one reference sputter source for generating a plasma from the process gas in order to sputter atoms, in particular ionised atoms, of reference target material off the reference sputter target of the respective one of the at least one reference sputter source as it is done for depositing the respective atoms on a substrate for depositing a material layer of the material potentially to be deposited on the substrate with the deposition apparatus. Thereby, advantageously, the at least one reference voltage source is of the same type as the at least one voltage source employed in the deposition apparatus. Furthermore, in the method for generating the tuning data set, a time the atoms, in particular ionised atoms, of the reference sputter target of the at least one reference sputter source require to reach from the reference sputter target of the respective one of the at least one reference sputter source to a substrate position in the reference deposition chamber is measured, the substrate position corresponding to a position of the substrate in the deposition chamber of the deposition apparatus when a material layer of the material potentially to be deposited on the substrate is effectively deposited with the deposition apparatus, wherein the measured time linked with the material of the reference target material or the type of reference sputter source is added to the tuning data set.

The time the atoms, in particular ionised atoms, of the reference sputter target of the at least one reference sputter source require to reach from the reference sputter target of the respective one of the at least one reference sputter source to the substrate position in the reference deposition chamber can for example be measured at the substrate position with a time resolved mass spectrometer, in particular with a time resolved time-of-flight mass spectrometer or can for example be measured with a retarding field energy analyser (RFEA). Such time resolved mass spectrometers as well as such retarding field energy analysers (RFEA) are known in the art.

When applying a voltage pulse with the at least one voltage source to the at least one sputter source for generating the plasma from the process gas in order to sputter atoms, in particular ionised atoms, of target material off the sputter target of the respective one of the at least one sputter source for depositing the respective atoms on the substrate for depositing the material layer on the substrate, the plasma is generated from the process gas. Thereby, due to a discharge at the sputter target of the respective one of the at least one sputter source, the major amount of plasma is generated in the vicinity of the respective one of the at least sputter source. In this plasma, the electrons are moving much faster than the ions of the ionised process gas. Due to these electrons of the plasma, the surface of the substrate and, as the material layer is deposited on the substrate, the surface of the material layer being deposited becomes negatively biased.

This negative bias occurs almost instantaneous. In particular on the time scale of the time the atoms, in particular ionised atoms, of target material sputtered off the sputter target of the respective one of the at least one sputter source for depositing the respective atoms on the substrate for depositing the material layer on the substrate require to reach from the sputter target to the substrate, this negative bias occurs instantaneous.

According to the invention, the offset in time corresponds to the time the atoms, in particular ionised atoms, of the sputter target of the key one of the at least one sputter source require to reach from the sputter target of the key one of the at least one sputter source to the substrate after a voltage pulse is applied to the key one of the at least one sputter source for generating the plasma from the process gas in order to sputter atoms, in particular ionised atoms, of the target material off the sputter target of the key one of the at least one sputter source. In that according to the invention, the voltage pulses applied to the synchronisable one of the at least one sputter source are delayed by the offset in time as compared to the voltage pulses applied to the key one of the at least one sputter source, the voltage pulses applied to the synchronisable one of the at least one sputter source cause a negative bias of the surface of the substrate and, as the material layer is deposited on the substrate, of the surface of the material layer being deposited at the time the atoms, in particular ionised atoms, of the sputter target of the key one of the at least one sputter source which have been sputtered off the sputter target of the key one of the at least one sputter source the offset in time ago reach the substrate. Thus, these atoms, in particular ionised atoms, of the sputter target of the key one of the at least one sputter source are accelerated by the negative bias onto the substrate and the material layer being deposited. This reduces defect concentration in the deposited material layer being deposited, improves the crystallinity of the material layer being deposited, and enables, as compared to known pulsed magnetron sputtering, in particular as compared to high-power impulse magnetron sputtering, a lower temperature of the substrate during deposition of the material layer.

Furthermore, according to the invention, the offset in time is longer than a majority of ions of the process gas require to reach from the plasma in the vicinity of the key one of the at least one sputter source to the substrate after a voltage pulse is applied to the key one of the at least one sputter source for generating the plasma from the process gas in order to sputter atoms, in particular ionised atoms, of the target material off the sputter target of the key one of the at least one sputter source. Thereby, whenever a voltage pulse is applied to the key one of the at least one sputter source for generating the plasma from the process gas in order to sputter atoms, in particular ionised atoms, of the target material off the sputter target of the key one of the at least one sputter source, due to a discharge at the sputter target of the key one of the at least one sputter source, the major amount of the plasma is generated from the process gas in the vicinity of the key one of the at least sputter source. Thus, as the offset in time is longer than a majority of ions of the process gas require to reach from this plasma in the vicinity of the key one of the at least one sputter source to the substrate after a voltage pulse is applied to the key one of the at least one sputter source, at the moment in time when the voltage pulses are applied to the synchronisable one of the at least one sputter source and cause the negative bias of the surface of the substrate, less ions of the process gas have reached the vicinity of the substrate. Consequently, when the voltage pulses are applied to the synchronisable one of the at least one sputter source and cause the negative bias of the surface of the substrate, less ions of the process gas are accelerated onto the substrate and the material layer being deposited.. This further reduces the introduction of defect into the material layer being deposited, improves the crystallinity of the material layer being deposited further and even reduces residual compressive stress in the material layer being deposited.

Consequently, the solution according to the invention has the advantage that the defect concentration in the deposited material layer being deposited is reduced, that the crystallinity of the material layer being deposited is improved, that residual compressive stress in the material layer being deposited is reduced and that the deposition of the material layer is enabled at a lower temperature of the substrate. The latter one is particular advantageous, in case the material of the material layer is a functional material like a semiconductor, a piezoelectric material, a ferroelectric material or even a transparent conductive oxide. Furthermore, this is advantageous in case a material layer is to be deposited on a temperature sensitive substrate like for example a polymeric substrate.

Furthermore, the solution according to the invention enables the deposition of material layers on insulating or electronically floating substrates and/or where the surface is structured or has a high aspect ratio. E.g., the solution according to the invention enables the deposition of material layers on trenches in semiconductor devices where the substrate is not electronically connected. Furthermore, the solution according to the invention enables the deposition of material layers where low deposition angles are used and high texture and crystalline quality of the deposited material layer are desired. E.g. typical research and development deposition apparatuses with confocal sputter geometry have deposition angles as low as 30°. Here, using the solution according the invention will lead to a deposited material layer texture closer to what is achieved with on-axis deposition (0°).

In the method according to the invention for depositing the material layer of the material to be deposited on the substrate by pulsed magnetron sputtering, in particular high-power impulse magnetron sputtering, the substrate is advantageously mounted on a substrate holder in the deposition chamber, wherein the substrate holder is arranged electronically floating in the deposition chamber.

In the method according to the invention for depositing the material layer of the material to be deposited on the substrate by pulsed magnetron sputtering, in particular high-power impulse magnetron sputtering, the offset in time is advantageously in the range from 5 µs to 500 µs, particular advantageously in the range from 5 µs to 100 µs. The offset in time may however as well be 5 µs, less than 5 µs, 500 µs or more than 500 µs.

In the method according to the invention for depositing the material layer of the material to be deposited on the substrate by pulsed magnetron sputtering, in particular high-power impulse magnetron sputtering, the at least one sputter source are advantageously at least two different sputter sources, wherein voltage pulses are applied with the at least one voltage source to the at least two sputter sources for generating a plasma from the process gas in order to sputter atoms, in particular ionised atoms, of target material off the sputter target of the respective one of the at least two sputter sources for depositing the respective atoms on the substrate for depositing the material layer on the substrate, wherein the voltage pulses applied to the synchronisable one of the at least two sputter sources are applied to the respective synchronisable one of the at least two sputter sources delayed by the offset in time as compared to the voltage pulses applied to the key one of the at least two sputter sources.

In a first preferred variant, the synchronisable one of the at least two sputter sources and the key one of the at least two sputter sources are the same sputter source.

In a second preferred variant, the synchronisable one of the at least two sputter sources and the key one of the at least two sputter sources are different sputter sources.

In this case, advantageously, the sputter target of the key one of the at least two sputter sources is made of at least one chemical element of the material to be deposited which is heavier than each one of the at least one chemical element the sputter target of the synchronisable one of the at least two sputter sources is made of.

This has the advantage that during the deposition of the material layer, the kinetic energy with which the at least one chemical element of the material to be deposited which is heavier than each one of the at least one chemical element the sputter target of the synchronisable one of the at least two sputter sources is made of hits the material layer being actually deposited is optimally suited for improving the film properties. In particular, this enables the deposition of material layers having a higher density and being more epitaxially grown.

Alternatively, the sputter target of the key one of the at least two sputter sources is not made of at least one chemical element of the material to be deposited which is heavier than each one of the at least one chemical element the sputter target of the synchronisable one of the at least two sputter sources is made of.

In a first preferred variation, the material of which the material layer is deposited on the substrate is piezoelectric material or a ferroelectric material, in particular a nitride piezoelectric based on AIN or a nitride ferroelectric material based on AIN. More preferably, the material is any one of AlScN, AlYN, AlCrN and an alloy of any combination of these materials.

In a second preferred variation, the material of which the material layer is deposited on the substrate is a ferroelectric oxide, in particular one of PbZr/TiO₃, BaTiO₃, PbTiO₃ and BiFeO₃.

With respect to these compounds, the method according to the invention has the advantage that the heavier ions can be accelerated using the substrate self-bias to improve the texture and crystallinity of the films while simultaneously keeping the defect concentration low.

In a third preferred variation, the material of which the material layer is deposited on the substrate is an electronically conductive compound, in particular one of TiN, TaN, WN, ZrN, SnO:ln and ZnO:Al.

With respect to these compounds, the method according to the invention has the advantage that the mechanical properties of the material layer can be improved without excess Ar incorporation in the material, which can be detrimental to the conductivity of the deposited material layer.

In the method for generating the tuning data set for a deposition apparatus for depositing the material layer of the material to be deposited on the substrate by pulsed magnetron sputtering, in particular high-power impulse magnetron sputtering, in order to enable depositing the material layer of the material to be deposited on the substrate with the deposition apparatus with the method according to the invention, advantageously, for depositing the material layer of the material potentially to be deposited on the substrate with the deposition apparatus, at least two sputter sources are required, wherein each of the at least two sputter sources includes a sputter target being made of at least one chemical element of the material potentially to be deposited on the substrate, wherein at least two reference sputter sources are arranged simultaneously or consecutively at their respective position inside the reference deposition chamber, wherein for each one of the at least two reference sputter sources, when the respective one of the at least two reference sputter sources are arranged inside the reference deposition chamber. Thereby, advantageously, the predetermined partial pressure of the process gas is maintained in the reference deposition chamber, and voltage pulses are applied with the at least one reference voltage source to the respective one of the at least two reference sputter sources for generating a plasma from the process gas in order to sputter atoms, in particular ionised atoms, of target material off the reference sputter target of the respective one of the at least two reference sputter sources as it is done for depositing the respective atoms on a substrate for depositing a material layer of the material potentially to be deposited on the substrate with the deposition apparatus. Furthermore, advantageously, the time the atoms, in particular ionised atoms, of the reference sputter target of the respective one of the at least two reference sputter sources require to reach from the reference sputter target of the respective one of the at least two reference sputter sources to the substrate position in the reference deposition chamber is measured, wherein the measured time linked with the material of the reference target material or the type of reference sputter source is added to the tuning data set.

During executing the method for generating the tuning data set, advantageously, the voltage pulses applied with the at least one reference voltage source to the at least one or at least two sputter sources have the same amplitude and time duration as the voltage pulses applied to the respective one of the at least one or at least two sputter sources when effectively depositing a material layer of the material potentially to be deposited on a substrate with the deposition apparatus.

Advantageously, the tuning data set is stored in a tuning data file on a data storage.

In the deposition apparatus, the offset in time is advantageously obtained from a tuning data set generated with the method for generating the tuning data set for the deposition apparatus for depositing the material layer of the material to be deposited on the substrate by pulsed magnetron sputtering, in particular high-power impulse magnetron sputtering, in order to enable depositing the material layer of the material to be deposited on the substrate with the deposition apparatus with the method according to the invention. Thereby, the offset time is advantageously the time measured during executing the method for generating the tuning data set the atoms, in particular ionised atoms, of the reference sputter target of the reference sputter source corresponding to the key one of the at least one sputter source required to reach from the sputter target of the reference sputter source corresponding to the key one of the at least one sputter source to the substrate position.

In this case, the control module is advantageously adapted to access the tuning data set stored in a tuning data file on a data storage for obtaining the offset in time from the tuning data set.

In a variant, the data storage is a server connected to the internet. In this variant, the data storage is not required to be part of the deposition apparatus. In another variant however, the data storage is a data storage of the deposition apparatus.

Advantageously, the deposition apparatus further includes a substrate holder for holding the substrate on which the material layer is to be deposited when depositing the material layer on the substrate.

Other advantageous embodiments and combinations of features come out from the detailed description below and the entirety of the claims.

### Brief description of the drawings

The drawings used to explain the embodiments show:
- Fig. 1: a strongly simplified schematic view of a deposition apparatus according to the invention for depositing a material layer of a material to be deposited on a substrate by high-power impulse magnetron sputtering with the method according to the invention,
- Fig. 2: a set of five measurements over time obtained from the deposition apparatus according to the invention during generating a tuning data set, and
- Fig. 3: measurements characterising samples of material layers deposited on different substrates with different methods, amongst others the method according to the invention.

In the figures, the same components are given the same reference symbols.

### Preferred embodiments

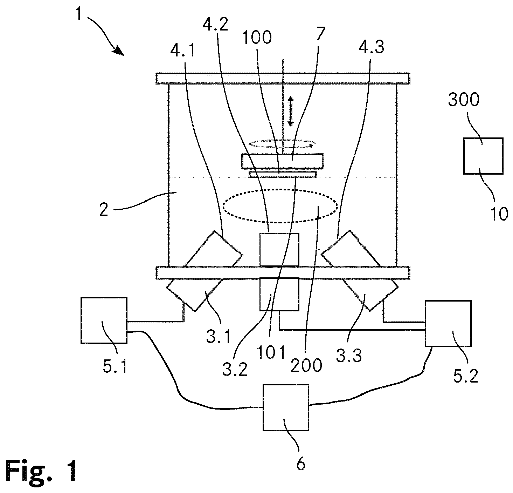

Figure 1 shows a strongly simplified schematic view of a deposition apparatus 1 according to the invention for depositing a material layer 101 of a material to be deposited on a substrate 100 by high-power impulse magnetron sputtering with the method according to the invention. This deposition apparatus 1 includes a deposition chamber 2 for containing a process gas at a predetermined partial pressure and three sputter sources 3.1, 3.2, 3.3, each one of the three sputter sources 3.1, 3.2, 3.3 including a sputter target 4.1, 4.2, 4.3 being made of at least one chemical element of the material to be deposited on the substrate 100. Furthermore, the deposition apparatus 1 includes two voltage sources 5.1, 5.2 for applying voltage pulses to the three sputter sources 3.1, 3.2, 3.3 for generating a plasma 200 from the process gas when the deposition chamber 2 contains the predetermined partial pressure of the process gas in order to sputter atoms, in particular ionised atoms, of target material off the sputter target 4.1, 4.2, 4.3 of the respective one of the three sputter sources 3.1, 3.2, 3.3 for depositing the respective atoms on the substrate 100 for depositing the material layer 101 on the substrate 100. Additionally the deposition apparatus 1 includes a substrate holder 7. During deposition of the material layer 101 on the substrate 100, the substrate 100 is mounted on this substrate holder 7. This substrate holder is arranged electronically floating in the deposition chamber 2. Thus, the substrate 100 mounted on the substrate holder 7 is as well arranged electronically floating in the deposition chamber 2.

Furthermore, the deposition apparatus 1 includes a control module 6 adapted to control the two voltage sources 5.1, 5.2 to apply to two of the three sputter sources 3.2, 3.3 the voltage pulses delayed by an offset in time as compared to the voltage pulses applied to a key one of the three sputter sources 3.1. These two of the three sputter sources 3.2, 3.3 are also referred to as two synchronisable sputter sources 3.2, 3.3. Thereby, the offset in time corresponds to a time the atoms, in particular ionised atoms, of the sputter target 4.1 of the key one of the sputter sources 3.1 require to reach from the sputter target 4.1 of the key one of the sputter sources 3.1 to the substrate 100 after a voltage pulse is applied to the key one of the sputter sources 3.1 for generating the plasma 200 from the process gas in order to sputter atoms, in particular ionised atoms, of the target material off the sputter target 4.1 of the key one of the sputter sources 3.1. Furthermore, the offset in time is longer than a majority of ions of the process gas require to reach from the plasma 200 in the vicinity of the key one of the sputter source 3.1 to the substrate 100 after a voltage pulse is applied to the key one of the sputter sources 3.1 for generating the plasma 200 from the process gas in order to sputter atoms, in particular ionised atoms, of the target material off the sputter target 4.1 of the key one of the sputter sources 3.1.

In an example where the deposition apparatus 1 is operated with the method according to the invention for depositing the material layer 101 of Aluminium Scandium Nitride (AlScN) to be deposited on a substrate 100 by high-power impulse magnetron sputtering, the sputter target 4.1 of the key one of the sputter sources 3.1 consists of scandium (Sc), while the sputter targets 4.2, 4.3 of the two synchronisable sputter sources 3.2, 3.3 consists of aluminium (Al). Thus, the sputter target 4.1 of the key one of the two sputter sources 3.1 is made of a chemical element of the material to be deposited which is heavier than the chemical element the sputter targets 4.2, 4.3 of the two the three sputter sources 3.2, 3.3 is made of.

In this example, the substrate 100 is arranged in the deposition chamber 2 and during deposition, the substrate 100 is held at a temperature of 100°C with the use of a heating and temperature control of the substrate holder 7. Thereby, a predetermined partial pressure of the process gas of 3 µbar is maintained in the deposition chamber 2. Additionally, nitrogen is introduced into the deposition chamber 2 to a partial pressure of nitrogen of 2 µbar resulting in a total working pressure of 5 µbar in the deposition chamber 2. Furthermore, during deposition, the three sputter sources 3.1, 3.2, 3.3 are arranged in the deposition chamber 2, the two sputter sources 3.1, 3.2, 3.3 each including a sputter target 4.1, 4.2, 4.3 being made of at least one chemical element of the material to be deposited, e.g., made of scandium and made of aluminium, respectively. With the two voltage sources 5.1, 5.2, voltage pulses are applied to the three sputter sources 3.1, 3.2, 3.3 for generating the plasma 200 from the process gas in order to sputter atoms, in particular ionised atoms, of target material off the sputter target 4.1, 4.2, 4.3 of the respective one of the three sputter sources 3.1, 3.2, 3.3 for depositing the respective atoms on the substrate 100 for depositing the material layer 101 on the substrate 100. More precisely, the voltage pulses applied to the two synchronisable sputter sources 3.2, 3.3 are applied to the two synchronisable sputter sources 3.2, 3.3 delayed by an offset in time as compared to the voltage pulses applied to the key one of the three sputter sources 4.1. Thereby, the offset in time corresponds to a time the atoms, in particular ionised atoms, of the sputter target 4.1 of the key one of the three sputter sources 3.1 require to reach from the sputter target 4.1 of the key one of the three sputter sources 3.1 to the substrate 100 after a voltage pulse is applied to the key one of the three sputter sources 3.1 for generating the plasma 200 from the process gas in order to sputter atoms, in particular ionised atoms, of the target material off the sputter target 4.1 of the key one of the three sputter sources 3.1. Furthermore, the offset in time is longer than a majority of ions of the process gas require to reach from the plasma 200 in the vicinity of the key one of the sputter source 3.1 to the substrate 100 after a voltage pulse is applied to the key one of the three sputter sources 3.1 for generating the plasma 200 from the process gas in order to sputter atoms, in particular ionised atoms, of the target material off the sputter target 4.1 of the key one of the three sputter sources 3.1.

In order to facilitate the deposition of the material layer 101 of AlScN on the substrate 100 with the method according to the invention with the deposition apparatus 1, a tuning data set 300 has been generated with a method according to the invention for generating the tuning data set 300 for the deposition apparatus 1 for depositing a material layer 101 to be deposited on the substrate 100 by high-power impulse magnetron sputtering.

In the method for generating the tuning data set 300, at least one reference sputter source is arranged inside a reference deposition chamber of a reference apparatus of the same type as the deposition chamber 2 of the deposition apparatus 1. The at least one reference sputter source includes a reference sputter target being made of at least one chemical element of the material potentially to be deposited on a substrate with the deposition apparatus 1. In this method for generating the tuning data set 300, a predetermined partial pressure of a process gas is maintained in the reference deposition chamber. This predetermined partial pressure of the process gas is the same partial pressure of the same process gas which is used when effectively depositing a material layer of the material potentially to be deposited on a substrate 100 with the deposition apparatus 1. In the method for generating the tuning data set 300, voltage pulses are applied with at least one reference voltage source to the at least one reference sputter source for generating a plasma from the process gas in order to sputter atoms, in particular ionised atoms, of reference target material off the reference sputter target of the respective one of the at least one reference sputter source as it is done for depositing the respective atoms on a substrate 100 for depositing a material layer of the material potentially to be deposited on the substrate 100 with the deposition apparatus 1. Thereby, the at least one reference voltage source is of the same type as the at least one voltage source employed in the deposition apparatus 1. Furthermore, in the method for generating the tuning data set 300, a time the atoms, in particular ionised atoms, of the reference sputter target of the respective reference sputter source require to reach from the reference sputter target of the respective reference sputter source to a substrate position in the reference deposition chamber is measured, the substrate position corresponding to a position of the substrate 100 in the deposition chamber 2 of the deposition apparatus 1 when a material layer of the material potentially to be deposited on the substrate 100 is effectively deposited with the deposition apparatus 1, wherein the measured time linked with the material of the reference target material or the type of reference sputter source is added to the tuning data set.

In the present example, the method for generating the tuning data set 300 has been executed by using the deposition apparatus 1. Thus, the reference deposition chamber has been the deposition chamber 2 of the deposition apparatus 1. Furthermore, three reference sputter sources have been employed, these three reference sputter sources being the three sputter sources 3.1, 3.2, 3.3 and thus comprised the sputter targets 4.1, 4.2, 4.3 made of scandium and of aluminium, respectively. Furthermore, the two reference voltage sources have been the two voltage sources 5.1, 5.2. The predetermined partial pressure of the process gas maintained in the reference deposition chamber has thus been as well 3 µbar. Additionally, the nitrogen is introduced into the reference deposition chamber to a predetermined partial pressure of 2 µbar.

When executing the method for generating the tuning data set 300, the time the atoms, in particular ionised atoms, of the reference sputter target of the respective reference sputter source required to reach from the reference sputter target of the respective one of the at least one reference sputter source to the substrate position in the reference deposition chamber have been measured at the substrate position with a time resolved time-of-flight mass spectrometer. Instead of a time resolved mass spectrometer, a retarding field energy analyser (RFEA) can be used, too.

In the deposition apparatus 1, the control module 6 is adapted to access the tuning data set 300 stored in a tuning data file on a data storage 10 for obtaining the offset in time from the tuning data set 300. Thereby, in a first variant, the data storage 10 is part of the deposition apparatus 1. In a second variant, however, the data storage 10 is a server which is accessible by the deposition apparatus 1 via internet. Thus, in this second variant, the deposition apparatus 1 includes an interface to the internet and is connected via this interface to the internet for obtaining the tuning data set 300. Thus, in either variant, the offset in time is obtained from the tuning data set 300 generated with the method for generating the tuning data set 300 for the deposition apparatus 1 for depositing the material layer 101 of the material to be deposited on the substrate 100 by high-power impulse magnetron sputtering in order to enable depositing the material layer 101 of the material to be deposited on the substrate 100 with the deposition apparatus 1 with the method according to the invention.

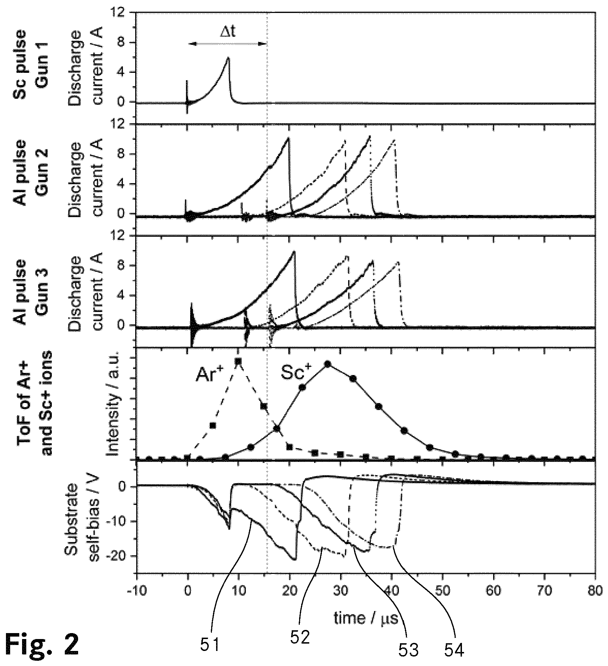

Figure 2 shows a set of five measurements over time obtained from the deposition apparatus 1 during generating the tuning data set 300 with the method described above. In the uppermost graph, the discharge current measured over time at the key one of the three sputter sources 3.1 carrying the sputter target 4.1 made from scandium (Sc) is shown. Thereby, the abscissa is given in microseconds, wherein zero in the timeline is set with the onset of the discharge current measured during one voltage pulse applied by a first one of the two voltage sources 5.1 to the key one of the three sputter sources 3.1.

The second lowest graph in Figure 2 shows the arrival times of plasma ions being argon ions at the position of the substrate 100 and the arrival times of scandium ions sputtered off the sputter target 4.1 of the key one of the three sputter sources 3.1 during one voltage pulse applied by the first one of the two voltage sources 5.1 to the key one of the three sputter sources 3.1. These measurements have been made with a time resolved time-of-flight mass spectrometer. They show that about 10 µs after the onset of the discharge current resulting essentially instantaneously after the voltage pulse being applied to the key one of the three sputter sources 3.1, the highest impact rate of argon ions is measured at the position of the substrate 100. The highest impact rate of scandium ions at the position of the substrate 100 is however measured about 27 µs after the onset of the discharge current resulting essentially instantaneously after the voltage pulse being applied to the key one of the three sputter sources 3.1.

The second upper graph of Figure 2 shows four measurements of the discharge current measured over time at a first one of the two synchronisable sputter sources 3.2 carrying the sputter target 4.2 made from aluminium (Al). The abscissa is again given in microseconds, wherein zero in the timeline is set with the onset of the discharge current measured during one voltage pulse applied by the first one of the two voltage sources 5.1 to the key one of the three sputter sources 3.1. Thereby, the four measurements have been obtained by employing no offset in time between the voltage pulse applied by the first one of the two voltage sources 5.1 to the key one of the three sputter sources 3.1 and the voltage pulse applied by a second one of the two voltage sources 5.2 to the two synchronisable sputter sources 3.2, 3.3 and by employing three different offsets in time between the voltage pulse applied by the first one of the two voltage sources 5.1 to the key one of the three sputter sources 3.1 and the voltage pulse applied by the second one of the two voltage sources 5.2 to the two synchronisable sputter sources 3.2, 3.3. Thereby, once, the offset in time is 11 µs, once, the offset in time is 16 µs, and once, the offset in time is 21 µs.

The third upper graph of Figure 2 shows four measurements of the discharge current measured over time at a second one of the two synchronisable sputter sources 3.3 carrying the sputter target 4.3 made from aluminium (Al) measured under the same circumstances as the measurements of the discharge current measured over time at the first one of the two synchronisable sputter sources 3.2 shown in the second upper graph in Figure 2.

Since in the plasma, the electrons are moving much faster than the ions of the ionised process gas, the surface of the substrate 100 and, as the material layer 101 is deposited on the substrate 100, the surface of the material layer 101 being deposited becomes negatively biased by the electrons arriving on the substrate 100 or material layer 101, respectively. This negative bias or self-bias of the substrate 100 occurs almost instantaneous with the onset of a voltage pulse applied to one of the sputter sources 3.1, 3.2, 3.3 and thus with the onset of the discharge current measured at the respective sputter source 3.1, 3.2, 3.3.

The lowest graph of Figure 2 shows the substrate self-bias caused by the voltage pulses applied with the voltage sources 5.1, 5.2 to the three sputter sources 3.1, 3.2, 3.3 for the four described measurements with no offset in time between the voltage pulse applied by the first one of the two voltage sources 5.1 to the key one of the three sputter sources 3.1 and the voltage pulse applied by the two voltage sources 5.2 to the two synchronisable sputter sources 3.2, 3.3 and with the three different offsets of 11 µs, 16 µs and 17 µs, respectively, in time between the voltage pulse applied by the first one of the two voltage sources 5.1 to the key one of the three sputter sources 3.1 and the voltage pulse applied by the two voltage sources 5.2 to the two synchronisable sputter sources 3.2, 3.3.

This measurements of the self-bias of the substrate 100 shown in the lowest graph of Figure 2 have been obtained with an oscilloscope connected to the substrate holder 7.

As can be seen in the lowest graph of Figure 2, in the curve 51 with no offset in time, the strongest self-bias occurs at about 21 µs, which corresponds to the position of the highest peaks of the discharge current measured at the two synchronisable sputter sources 3.2, 3.3. This is after the highest impact rate of argon ions on the substrate 100 and before the highest impact rate of the scandium ions on the substrate 100. In the curve 52 with the offset in time of 11 µs, the strongest self-bias occurs at about 31 µs, which corresponds to the position of the highest peaks of the discharge current measured at the two synchronisable sputter sources 3.2, 3.3. Thereby, the onset of the self-bias is at a time when still quite some argon ions arrive at the substrate 100. In the curve 53 with the offset in time of 16 µs, the strongest self-bias occurs at about 36 µs, which corresponds to the position of the highest peaks of the discharge current measured at the two synchronisable sputter sources 3.2, 3.3. Here, the onset of the self-bias is after the major part of the argon ions have arrive at the substrate 100. At the same time, the self-bias of the substrate 100 occurs during that time when the major part of the scandium ions arrive at the substrate 100. In the curve 54 with the offset in time of 21 µs, the strongest self-bias occurs at about 42 µs, which corresponds to the position of the highest peaks of the discharge current measured at the two synchronisable sputter sources 3.2, 3.3. Here, the onset of the self-bias is well after the major part of the argon ions have arrive at the substrate 100. However, the self-bias of the substrate 100 occurs also somewhat after the major part of the scandium ions arrive at the substrate 100.

For these reasons, the optimal offset in time is 16 µs. During generating the tuning data set 300, this offset is determined as the optimal offset in time for the present setup and configuration of the deposition apparatus 1. Consequently, this offset in time is stored in the tuning data set 300 for the present setup of the deposition apparatus 1.

In order to illustrate how the method according to the invention for depositing a material layer of a material to be deposited on a substrate by high-power impulse magnetron sputtering provides advantages over other methods, four Aluminium Scandium Nitride (AlScN) - layers have been deposited on substrates made of glass, substrates made of silicon and substrates made of sapphire, wherein for each substrate type, once, no offset in time was used, once, the offset in time was 11 µs, once, the offset in time was 16 µs, and once, the offset in time was 21 µs. Thereby, the samples where no offset in time was employed was referred to as sync-type "A". The samples where the offset in time of 11 µs was employed was referred to as sync-type "B". The samples where the offset in time of 16 µs was employed was referred to as sync-type "C". The samples where the offset in time of 21 µs was employed was referred to as sync-type "D".

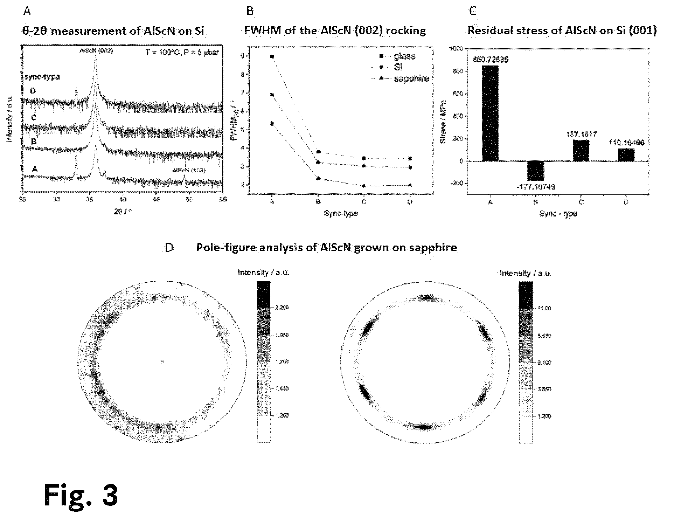

Figure 3 shows the measurements with which these samples where characterised. Diagram A shows Bragg-Brentano X-ray-diffraction *θ* - 2*θ* - scans performed on the samples with the Silicon (001) substrates. Thereby, for all sync-types, the AlScN (002)-Peak is well visible. However, in the sync-type A-sample where no offset in time was employed, strong reflections for other planes are visible as well as an AlSnN (103)-peak indicating at least some grains of AlScN in the material layer having a different orientation than the rest of the material layer.

Diagram B of Figure 3 shows the Full Width at Half Maximum of the AlScN (002) rocking curves obtained with X-ray-diffraction for all samples. Eventually, all samples of the sync-type A where no offset in time was employed, the Full Width at Half Maximum is considerably larger than for the other sync-types indicating a less homogeneous material layer for the sync type A-samples than for the other sync-type samples. Furthermore, the Full Width at Half Maximum of the sync type C and D samples is somewhat larger than the Full Width at Half Maximum for the sync type B sample, indicating somewhat less mosaicity in the material layer for the sync type C and D samples.

Diagram C of Figure 3 shows measurements of the residual stress of the material layer on the Silicon (001) - substrates. Here, the sync type A sample shows a rather high tensile stress, while the sync type B sample shows a light compressive stress most likely due to an argon ion bombardment during the deposition of the AlScN material layer. Furthermore, sync type C and sync type D layer show a slight tensile stress again.

Diagram D of Figure 3 shows a pole figure analysis of the material layers on the sapphire (001) substrates. Thereby, the Figure on the left shows the measurement for the sync type A sample, while the Figure on the right shows the measurement for the sync type C sample. Very clearly, the sync type C sample shows a considerably better crystallinity than the sync type A sample.

Thus, it becomes clear that the sync type samples where the offset in time was in the range from 16 µs and 21 µs have the lowest defect concentration and thus an improved material layer quality. The material layers of these samples where grown at a substrate temperature of 100°C, which is a comparably low temperature.

The invention is not limited to the examples provided in the context of the figures. Furthermore, the material layer 101 is not required to be AlScN. For example, the material of which the material layer 101 is deposited on the substrate 100 can be a piezoelectric material or a ferroelectric material. For example, the material can be a nitride piezoelectric based on AIN or a nitride ferroelectric material based on AlN. However, the material can be any one of AlScN, AlYN, AlCrN or an alloy of these materials. In another example, the material of which the material layer 101 is deposited on the substrate 100 is ferroelectric oxide, in particular one of PbZr/TiO₃, BaTiO₃, PbTiO₃ and BiFeO₃. In yet another example, the material of which the material layer 101 is deposited on the substrate 100 is an electronically conductive compound, in particular one of TiN, TaN, WN, ZrN, SnO:ln and ZnO:Al.

In summary, it is to be noted that a method for depositing a material layer of a material to be deposited on a substrate by pulsed magnetron sputtering, in particular high-power impulse magnetron sputtering, is provided that enables the deposition of a material layer with improved properties like for example a lower defect concentration, an improved crystallinity and a reduced residual compressive stress and also enables the deposition of a material layer with an material layer with improved properties at a comparably lower deposition temperature. Furthermore, a deposition apparatus is provided for depositing a material layer of a material to be deposited on a substrate by pulsed magnetron sputtering, in particular high-power impulse magnetron sputtering, with the method according to the invention.

## Claims

1. Method for depositing a material layer (101) of a material to be deposited on a substrate (100) by pulsed magnetron sputtering, in particular high-power impulse magnetron sputtering, wherein
a) a predetermined partial pressure of a process gas is maintained in a deposition chamber (2),
b) the substrate (100) is arranged in the deposition chamber (2),
c) at least one sputter source (3.1, 3.2, 3.3) is arranged in the deposition chamber (2), the at least one sputter source (3.1, 3.2, 3.3) including a sputter target (4.1, 4.2, 4.3) being made of at least one chemical element of the material to be deposited,
d) voltage pulses are applied with at least one voltage source (5.1, 5.2) to the at least one sputter source (3.1, 3.2, 3.3) for generating a plasma (200) from the process gas in order to sputter atoms, in particular ionised atoms, of target material off the sputter target (4.1, 4.2, 4.3) of the respective one of the at least one sputter source (3.1, 3.2, 3.3) for depositing the respective atoms on the substrate (100) for depositing the material layer on the substrate (100),
wherein the voltage pulses applied to a synchronisable one of the at least one sputter source (3.1, 3.2, 3.3) are applied to the synchronisable one of the at least one sputter source (3.2, 3.3) delayed by an offset in time as compared to the voltage pulses applied to a key one of the at least one sputter source (3.1),
i) wherein the offset in time corresponds to a time the atoms, in particular ionised atoms, of the sputter target (4.1) of the key one of the at least one sputter source (3.1) require to reach from the sputter target (4.1) of the key one of the at least one sputter source (3.1) to the substrate (100) after a voltage pulse is applied to the key one of the at least one sputter source (3.1) for generating the plasma (200) from the process gas in order to sputter atoms, in particular ionised atoms, of the target material off the sputter target (4.1) of the key one of the at least one sputter source (3.1), and
ii) wherein the offset in time is longer than a majority of ions of the process gas require to reach from the plasma (200) in a vicinity of the key one of the at least one sputter source (3.1) to the substrate (100) after a voltage pulse is applied to the key one of the at least one sputter source (3.1) for generating the plasma (200) from the process gas in order to sputter atoms, in particular ionised atoms, of the target material off the sputter target (4.1) of the key one of the at least one sputter source (3.1).

2. Method according to claim 1, wherein the substrate (100) is mounted on a substrate holder (7) in the deposition chamber (2), wherein the substrate holder (7) is arranged electronically floating in the deposition chamber (2).

3. Method according to claim 1 or 2, wherein the offset in time is in the range from 5 µs to 500 µs, in particular in the range from 5 µs to 100 µs.

4. Method according to any one of claims 1 to 3 wherein the at least one sputter source (3.1, 3.2, 3.3) are at least two different sputter sources (3.1, 3.2, 3.3), wherein voltage pulses are applied with the at least one voltage source (5.1, 5.2) to the at least two sputter sources (3.1, 3.2, 3.3) for generating a plasma (200) from the process gas in order to sputter atoms, in particular ionised atoms, of target material off the sputter target (4.1, 4.2, 4.2) of the respective one of the at least two sputter sources (3.1, 3.2, 3.3) for depositing the respective atoms on the substrate (100) for depositing the material layer (101) on the substrate (100), wherein the voltage pulses applied to the synchronisable one of the at least two sputter sources (3.2, 3.3) are applied to the rsynchronisable one of the at least two sputter sources (3.2, 3.3) delayed by the offset in time as compared to the voltage pulses applied to the key one of the at least two sputter sources (3.1).

5. Method according to claim 4, wherein the synchronisable one of the at least two sputter sources (3.2, 3.3) and the key one of the at least two sputter sources (3.1) are different sputter sources.

6. Method according to claim 5, wherein the sputter target (4.1) of the key one of the at least two sputter sources (3.1) is made of at least one chemical element of the material to be deposited which is heavier than each one of the at least one chemical element the sputter target (4.2, 4.3) of the synchronisable one of the at least two sputter sources (3.2, 3.3) is made of.

7. Method according to any one of claims 1 to 6, wherein the material of which the material layer (101) is deposited on the substrate (100) is piezoelectric material or a ferroelectric material, in particular a nitride piezoelectric based on AIN or a nitride ferroelectric material based on AlN.

8. Method according to any one of claims 1 to 6, wherein the material of which the material layer (101) is deposited on the substrate (100) is ferroelectric oxide, in particular one of PbZr/TiO₃, BaTiO₃, PbTiO₃ and BiFeO₃.

9. Method according to any one of claims 1 to 6, wherein the material of which the material layer (101) is deposited on the substrate (100) is an electronically conductive compound, in particular one of TiN, TaN, WN, ZrN, SnO:ln and ZnO:Al.

10. Method for generating a tuning data set (300) for a deposition apparatus (1) for depositing a material layer (101) of a material to be deposited on a substrate (100) by pulsed magnetron sputtering, in particular high-power impulse magnetron sputtering, in order to enable depositing the material layer (101) of the material to be deposited on the substrate (100) with the deposition apparatus (1) with the method according to any one of claims 1 to 9, wherein the deposition apparatus (1) includes a deposition chamber (2), wherein in the method for generating the tuning data set (300),
a) at least one reference sputter source is arranged inside a reference deposition chamber of a reference apparatus of the same type as the deposition chamber (2) of the deposition apparatus (1), the at least one reference sputter source including a reference sputter target being made of at least one chemical element of the material potentially to be deposited on a substrate (100) with the deposition apparatus (1),
b) a predetermined partial pressure of a process gas is maintained in the reference deposition chamber,
c) voltage pulses are applied with at least one reference voltage source to the at least one reference sputter source for generating a plasma from the process gas in order to sputter atoms, in particular ionised atoms, of reference target material off the reference sputter target of the respective one of the at least one reference sputter source as it is done for depositing the respective atoms on a substrate (100) for depositing a material layer (101) of the material potentially to be deposited on the substrate (100) with the deposition apparatus (1), and
d) a time the atoms, in particular ionised atoms, of the reference sputter target of the at least one reference sputter source require to reach from the reference sputter target of the respective one of the at least one reference sputter source to a substrate position in the reference deposition chamber is measured, the substrate position corresponding to a position of the substrate (100) in the deposition chamber (2) of the deposition apparatus (1) when a material layer (101) of the material potentially to be deposited on the substrate (100) is effectively deposited with the deposition apparatus (1), wherein the measured time linked with the material of the reference target material or the type of reference sputter source is added to the tuning data set (300).

11. Method according to claim 10, wherein for depositing a material layer (101) of the material potentially to be deposited on the substrate (100) with the deposition apparatus (1), at least two sputter sources (3.1, 3.2, 3.3) are required, wherein each of the at least two sputter sources (3.1, 3.2, 3.3) includes a sputter target (4.1, 4.2, 4.3) being made of at least one chemical element of the material potentially to be deposited on the substrate (100),
wherein at least two reference sputter sources are arranged simultaneously or consecutively at their respective position inside the reference deposition chamber, wherein for each one of the at least two reference sputter sources, when the respective one of the at least two reference sputter sources are arranged inside the reference deposition chamber,
- the predetermined partial pressure of the process gas is maintained in the reference deposition chamber,
- voltage pulses are applied with the at least one reference voltage source to the respective one of the at least two reference sputter sources for generating a plasma from the process gas in order to sputter atoms, in particular ionised atoms, of target material off the reference sputter target of the respective one of the at least two reference sputter sources as it is done for depositing the respective atoms on a substrate (100) for depositing a material layer (101) of the material potentially to be deposited on the substrate (100) with the deposition apparatus (1),
- the time the atoms, in particular ionised atoms, of the reference sputter target of the respective one of the at least two reference sputter sources require to reach from the reference sputter target of the respective one of the at least two reference sputter sources to the substrate position in the reference deposition chamber is measured, wherein the measured time linked with the material of the reference target material or the type of reference sputter source is added to the tuning data set (300).

12. Method according to claim 10 or 11, wherein the tuning data set (300) is stored in a tuning data file on a data storage (10).

13. Deposition apparatus (1) for depositing a material layer (100) of a material to be deposited on a substrate (100) by pulsed magnetron sputtering, in particular high-power impulse magnetron sputtering, with the method according to any one of claims 1 to 9, wherein the deposition apparatus (1) includes
a) a deposition chamber (1) for containing a process gas at a predetermined partial pressure,
b) at least one sputter source (3.1, 3.2, 3.3), in particular at least two sputter sources (3.1, 3.2, 3.3), each one of the at least one sputter source (3.1, 3.2, 3.3) including a sputter target (4.1, 4.2, 4.3) being made of at least one chemical element of the material to be deposited on the substrate (100),
c) at least one voltage source (5.1, 5.2) for applying voltage pulses to the at least one sputter source (3.1, 3.2, 3.3) for generating a plasma (200) from the process gas when the deposition chamber (2) contains the predetermined partial pressure of the process gas in order to sputter atoms, in particular ionised atoms, of target material off the sputter target (4.1, 4.2, 4.3) of the respective one of the at least one sputter source (3.1, 3.2, 3.3) for depositing the respective atoms on the substrate (100) for depositing the material layer (101) on the substrate (100),
d) a control module (6) adapted to control the at least one voltage source (5.1, 5.2) to apply to a synchronisable one of the at least one sputter source (3.2, 3.3) the voltage pulses delayed by an offset in time as compared to the voltage pulses applied to a key one of the at least one sputter source (3.1),
i) wherein the offset in time corresponds to a time the atoms, in particular ionised atoms, of the sputter target (4.1) of the key one of the at least one sputter source (3.1) require to reach from the sputter target (4.1) of the key one of the at least one sputter source (3.1) to the substrate (100) after a voltage pulse is applied to the key one of the at least one sputter source (3.1) for generating the plasma (200) from the process gas in order to sputter atoms, in particular ionised atoms, of the target material off the sputter target (4.1) of the key one of the at least one sputter source (3.1), and
ii) wherein the offset in time is longer than a majority of ions of the process gas require to reach from the plasma (200) in the vicinity of the key one of the at least one sputter source (3.1) to the substrate (100) after a voltage pulse is applied to the key one of the at least one sputter source (3.1) for generating the plasma (200) from the process gas in order to sputter atoms, in particular ionised atoms, of the target material off the sputter target (4.1) of the key one of the at least one sputter source (3.1).

14. Deposition apparatus (1) according to claim 13, wherein the offset in time is obtained from a tuning data set (300) generated with the method according to any one of claims 10 to 12, wherein the offset time is the time measured during executing the method according to any one of claims 10 to 12 the atoms, in particular ionised atoms, of the reference sputter target of the reference sputter source corresponding to the key one of the at least one sputter source (3.1) required to reach from the reference sputter target of the reference sputter source corresponding to the key one of the at least one sputter source (3.1) to the substrate position.

15. Deposition apparatus according to claim 14, wherein the control module (6) is adapted to access the tuning data set (300) stored in a tuning data file on a data storage (10) for obtaining the offset in time from the tuning data set (300).

## Patentansprüche

1. Verfahren zum Aufbringen einer Materialschicht (101) aus einem aufzubringenden Material auf ein Substrat (100) mittels gepulstem Magnetron-Sputtern, insbesondere Hochleistungs-Impuls-Magnetron-Sputtern, wobei
a) in einer Abscheidungskammer (2) ein vorbestimmter Partialdruck eines Prozessgases aufrechterhalten wird,
b) das Substrat (100) in der Abscheidungskammer (2) angeordnet ist,
c) in der Abscheidungskammer (2) mindestens eine Sputterquelle (3.1, 3.2, 3.3) angeordnet ist, wobei die mindestens eine Sputterquelle (3.1, 3.2, 3.3) ein Sputtertarget (4.1, 4.2, 4.3) umfasst, das aus mindestens einem chemischen Element des abzuscheidenden Materials besteht,
d) Spannungspulse über mindestens eine Spannungsquelle (5.1, 5.2) an die mindestens eine Sputterquelle (3.1, 3.2, 3.3) angelegt werden, um aus dem Prozessgas ein Plasma (200) zu erzeugen, damit Atome, insbesondere ionisierte Atome, des Targetmaterials vom Sputtertarget (4.1, 4.2, 4.3) der jeweiligen der mindestens einen Sputterquelle (3.1, 3.2, 3.3) abzusputtern, um die jeweiligen Atome auf dem Substrat (100) abzuscheiden und so die Materialschicht auf dem Substrat (100) abzuscheiden,
wobei die an eine synchronisierbare der mindestens einen Sputterquelle (3.1, 3.2, 3.3) angelegten Spannungspulse an die synchronisierbare der mindestens einen Sputterquelle (3.2, 3.3) mit einem Zeitversatz im Vergleich zu den an eine Schlüsselquelle der mindestens einen Sputterquelle (3.1) angelegten Spannungspulsen angelegt werden,
i) wobei der Zeitversatz der Zeit entspricht, die die Atome, insbesondere ionisierte Atome, des Sputtertargets (4.1) der Schlüsselquelle der mindestens einen Sputterquelle (3.1) benötigen, um vom Sputtertarget (4.1) der Schlüsselquelle der mindestens einen Sputterquelle (3.1) zum Substrat (100) zu gelangen, nachdem ein Spannungspuls an die Schlüsselquelle der mindestens einen Sputterquelle (3.1) angelegt wurde, um aus dem Prozessgas das Plasma (200) zu erzeugen, damit Atome, insbesondere ionisierte Atome, des Targetmaterials vom Sputtertarget (4.1) der Schlüsselquelle der mindestens einen Sputterquelle (3.1) abgetragen werden, und
ii) wobei der Zeitversatz länger ist, als die Mehrheit der Ionen des Prozessgases benötigt, um vom Plasma (200) in der Nähe der Schlüsselquelle der mindestens einen Sputterquelle (3.1) zum Substrat (100) zu gelangen, nachdem ein Spannungspuls an die Schlüsselquelle der mindestens einen Sputterquelle (3.1) angelegt wurde, um das Plasma (200) aus dem Prozessgas zu erzeugen, um Atome, insbesondere ionisierte Atome, des Targetmaterials vom Sputtertarget (4.1) der Schlüsselquelle der mindestens einen Sputterquelle (3.1) abzusputtern.

2. Verfahren nach Anspruch 1, wobei das Substrat (100) auf einem Substrathalter (7) in der Abscheidungskammer (2) befestigt ist, wobei der Substrathalter (7) elektrisch schwebend in der Abscheidungskammer (2) angeordnet ist.

3. Verfahren nach Anspruch 1 oder 2, wobei der Zeitversatz im Bereich von 5 µs bis 500 µs, insbesondere im Bereich von 5 µs bis 100 µs, liegt.

4. Verfahren nach einem der Ansprüche 1 bis 3, wobei die mindestens eine Sputterquelle (3.1, 3.2, 3.3) mindestens zwei verschiedene Sputterquellen (3.1, 3.2, 3.3) sind, wobei mit der mindestens einen Spannungsquelle (5.1, 5.2) Spannungspulse an die mindestens zwei Sputterquellen (3.1, 3.2, 3.3) angelegt werden, um aus dem Prozessgas ein Plasma (200) zu erzeugen, um Atome, insbesondere ionisierte Atome, des Targetmaterials vom Sputtertarget (4.1, 4.2, 4.2) der jeweiligen der mindestens zwei Sputterquellen (3.1, 3.2, 3.3) abzusputtern, um die jeweiligen Atome auf dem Substrat (100) abzuscheiden und die Materialschicht (101) auf dem Substrat (100) abzuscheiden, wobei die Spannungspulse mit einem Zeitversatz im Vergleich zu den an die Schlüsselquelle der mindestens einen Sputterquelle (3.1) angelegten Spannungspulsen an die synchronisierbare der mindestens zwei Sputterquellen (3.2, 3.3) angelegt werden.

5. Verfahren nach Anspruch 4, wobei die synchronisierbare der mindestens zwei Sputterquellen (3.2, 3.3) und die Schlüsselquelle der mindestens zwei Sputterquellen (3.1) unterschiedliche Sputterquellen sind.

6. Verfahren nach Anspruch 5, wobei das Sputtertarget (4.1) der Schlüsselquelle der mindestens einen Sputterquelle (3.1) aus mindestens einem chemischen Element des abzuscheidenden Materials besteht, das schwerer ist als jedes der mindestens einen chemischen Elemente, aus denen das Sputtertarget (4.2, 4.3) der synchronisierbaren der mindestens zwei Sputterquellen (3.2, 3.3) besteht.

7. Verfahren nach einem der Ansprüche 1 bis 6, wobei das Material, aus dem die Materialschicht (101) auf dem Substrat (100) abgeschieden ist, ein piezoelektrisches Material oder ein ferroelektrisches Material ist, insbesondere ein piezoelektrisches Nitrid auf AlN-Basis oder ein ferroelektrisches Nitridmaterial auf AlN-Basis.

8. Verfahren nach einem der Ansprüche 1 bis 6, wobei das Material, aus dem die Materialschicht (101) auf dem Substrat (100) abgeschieden ist, ein ferroelektrisches Oxid ist, insbesondere PbZr/TiO₃, BaTiO₃, PbTiO₃ oder BiFeO₃.

9. Verfahren nach einem der Ansprüche 1 bis 6, wobei das Material, aus dem die Materialschicht (101) auf dem Substrat (100) abgeschieden wird, eine elektrisch leitfähige Verbindung ist, insbesondere TiN, TaN, WN, ZrN, SnO:In oder ZnO:Al.

10. Verfahren zum Erzeugen eines Abstimmungsdatensatzes (300) für eine Abscheidungsvorrichtung (1) zum Abscheiden einer Materialschicht (101) aus einem auf ein Substrat (100) aufzubringenden Material mittels gepulstem Magnetron-Sputtern, insbesondere Hochleistungs-Impuls-Magnetron-Sputtern, um das Abscheiden der Materialschicht (101) des aufzubringenden Materials auf das Substrat (100) mit der Abscheidungsvorrichtung (1) nach dem Verfahren gemäß einem der Ansprüche 1 bis 9 zu ermöglichen, wobei die Abscheidungsvorrichtung (1) eine Abscheidungskammer (2) umfasst, wobei bei in dem Verfahren zum Erzeugen des Abstimmungsdatensatzes (300),
a) mindestens eine Referenz-Sputterquelle innerhalb einer Referenz-Abscheidungskammer einer Referenzvorrichtung desselben Typs wie die Abscheidungskammer (2) der Abscheidungsvorrichtung (1) angeordnet ist, wobei die mindestens eine Referenz-Sputterquelle ein Referenz-Sputtertarget umfasst, das aus mindestens einem chemischen Element des Materials besteht, das mit der Abscheidungsvorrichtung (1) potenziell auf einem Substrat (100) abgeschieden werden soll,
b) in der Referenz-Abscheidungskammer ein vorgegebener Partialdruck eines Prozessgases aufrechterhalten wird,
c) Spannungspulse mit mindestens einer Referenz-Spannungsquelle an die mindestens eine Referenz-Sputterquelle angelegt werden, um aus dem Prozessgas ein Plasma zu erzeugen, damit Atome, insbesondere ionisierte Atome, des Targetmaterials von dem Referenz-Sputtertarget der jeweiligen der mindestens einen Referenz-Sputterquelle gesputtert werden, wie dies auch der Fall ist bei der Abscheidung der jeweiligen Atome auf einem Substrat (100) zur Abscheidung einer Materialschicht (101) des Materials, das potenziell auf das Substrat (100) mit der Abscheidungsvorrichtung (1) abgeschieden werden soll, und
d) die Zeit gemessen wird, die die Atome, insbesondere ionisierte Atome, des Referenz-Sputtertargets der mindestens eine Referenz-Sputterquelle benötigen, um vom Referenz-Sputtertarget der jeweiligen der mindestens eine Referenz-Sputterquelle zu einer Substratposition in der Referenz-Abscheidungskammer zu gelangen, wobei die Substratposition einer Position des Substrats (100) in der Abscheidungskammer (2) der Abscheidungsvorrichtung (1) entspricht, wenn eine Materialschicht (101) des Materials, das potenziell auf dem Substrat (100) abgeschieden werden soll, mit der Abscheidungsvorrichtung (1) effektiv abgeschieden wird, wobei die gemessene Zeit, die mit dem Material des Targetmaterials oder der Art der Referenz-Sputterquelle verknüpft ist, dem Abstimmungsdatensatz (300) hinzugefügt wird.

11. Verfahren nach Anspruch 10, wobei zum Aufbringen einer Materialschicht (101) aus dem potenziell auf das Substrat (100) aufzubringenden Material mit der Abscheidungsvorrichtung (1) mindestens zwei Sputterquellen (3.1, 3.2, 3.3) erforderlich sind, wobei jede der mindestens zwei Sputterquellen (3.1, 3.2, 3.3) ein Sputtertarget (4.1, 4.2, 4.3) umfasst, das aus mindestens einem chemischen Element des Materials besteht, das potenziell auf das Substrat (100) abgeschieden werden soll,
wobei mindestens zwei Referenz-Sputterquellen gleichzeitig oder nacheinander an ihrer jeweiligen Position innerhalb der Referenz-Abscheidungskammer angeordnet sind, wobei für jede der mindestens zwei Referenz-Sputterquellen, wenn die jeweilige der mindestens zwei Referenz-Sputterquellen innerhalb der Referenz-Abscheidungskammer angeordnet ist,
- der vorgegebene Partialdruck des Prozessgases in der Referenz-Abscheidungskammer aufrechterhalten wird,
- mit der mindestens einen Referenz-Spannungsquelle Spannungspulse an die jeweilige der mindestens zwei Referenz-Sputterquellen angelegt werden, um aus dem Prozessgas ein Plasma zu erzeugen, damit Atome, insbesondere ionisierte Atome, des Targetmaterials vom Referenz-Sputtertarget der jeweiligen der mindestens zwei Referenz-Sputterquellen gesputtert werden, wie dies mit der Abscheidungsvorrichtung (1) auch bei der Abscheidung der jeweiligen Atome auf einem Substrat (100) zur Abscheidung einer Materialschicht (101) des Materials, das potenziell auf das Substrat (100) abgeschieden werden soll, geschieht,
- die Zeit gemessen wird, die die Atome, insbesondere ionisierte Atome, des Referenz-Sputtertargets der jeweiligen der mindestens zwei Referenz-Sputterquellen benötigen, um vom Referenz-Sputtertarget der jeweiligen der mindestens zwei Referenz-Sputterquellen zur Substratposition in der Referenz-Abscheidungskammer zu gelangen, wobei die gemessene Zeit, die mit dem Targetmaterial des Referenz-Sputtertargets oder dem Typ der Referenz-Sputterquelle verknüpft ist, dem Abstimmungsdatensatz (300) hinzugefügt wird.

12. Verfahren nach Anspruch 10 oder 11, wobei der Abstimmungsdatensatz (300) in einer Abstimmdatendatei auf einem Datenspeicher (10) gespeichert ist.

13. Abscheidungsvorrichtung (1) zum Aufbringen einer Materialschicht (100) aus einem abzuscheidenden Material auf ein Substrat (100) mittels gepulstem Magnetron-Sputtern, insbesondere Hochleistungs-Impuls-Magnetron-Sputtern, mit dem Verfahren gemäß einem der Ansprüche 1 bis 9, wobei die Abscheidungsvorrichtung (1) Folgendes beinhaltet
a) eine Abscheidungskammer (1) zur Aufnahme eines Prozessgases bei einem vorgegebenen Partialdruck,
b) mindestens eine Sputterquelle (3.1, 3.2, 3.3), insbesondere mindestens zwei Sputterquellen (3.1, 3.2, 3.3), wobei jede der mindestens einen Sputterquelle (3.1, 3.2, 3.3) ein Sputtertarget (4.1, 4.2, 4.3), das aus mindestens einem chemischen Element des auf das Substrat (100) aufzubringenden Materials besteht,
c) mindestens eine Spannungsquelle (5.1, 5.2) zum Anlegen von Spannungspulsen an die mindestens eine Sputterquelle (3.1, 3.2, 3.3) zum Erzeugen eines Plasmas (200) aus dem Prozessgas, wenn die Abscheidungskammer (2) den vorbestimmten Partialdruck des Prozessgases enthält, um Atome, insbesondere ionisierte Atome, des Targetmaterials von dem Sputtertarget (4.1, 4.2, 4.3) der jeweiligen der mindestens einen Sputterquelle (3.1, 3.2, 3.3) abzusputtern, um die jeweiligen Atome auf dem Substrat (100) abzuscheiden und die Materialschicht (101) auf dem Substrat (100) abzuscheiden,
d) ein Steuermodul (6), das dazu ausgelegt ist, die mindestens eine Spannungsquelle (5.1, 5.2) so zu steuern, dass an eine synchronisierbare der mindestens einen Sputterquelle (3.2, 3.3) Spannungspulse angelegt werden, die gegenüber den an eine Schlüsselquelle der mindestens einen Sputterquelle (3.1) angelegten Spannungspulsen einen Zeitversatz aufweisen,
i) wobei der Zeitversatz der Zeit entspricht, die die Atome, insbesondere ionisierte Atome, des Sputtertargets (4.1) der Schlüsselquelle der mindestens einen Sputterquelle (3.1) benötigen, um vom Sputtertarget (4.1) der Schlüsselquelle der mindestens einen Sputterquelle (3.1) zum Substrat (100) zu gelangen, nachdem ein Spannungspuls an die Schlüsselquelle der mindestens einen Sputterquelle (3.1) angelegt wurde, um aus dem Prozessgas das Plasma (200) zu erzeugen, damit Atome, insbesondere ionisierte Atome, des Targetmaterials vom Sputtertarget (4.1) der Schlüsselquelle der mindestens einen Sputterquelle (3.1) abgetragen werden, und
ii) wobei der Zeitversatz länger ist als die Mehrheit der Ionen des Prozessgases benötigt, um vom Plasma (200) in der Nähe der Schlüsselquelle der mindestens einen Sputterquelle (3.1) zum Substrat (100) zu gelangen, nachdem ein Spannungspuls an die Schlüsselquelle der mindestens einen Sputterquelle (3.1) angelegt wurde, um das Plasma (200) aus dem Prozessgas zu erzeugen, um Atome, insbesondere ionisierte Atome, des Targetmaterials vom Sputtertarget (4.1) der Schlüsselquelle der mindestens einen Sputterquelle (3.1) abzusputtern.

14. Abscheidungsvorrichtung (1) nach Anspruch 13, wobei der Zeitversatz aus einem Abstimmungsdatensatz (300) abgeleitet wird, der mit dem Verfahren gemäß einem der Ansprüche 10 bis 12 erzeugt wurde, wobei der Zeitversatz die Zeit ist, die während der Ausführung des Verfahrens gemäß einem der Ansprüche 10 bis 12 gemessen wird, welche die Atome, insbesondere ionisierte Atome, des Referenz-Sputtertargets der Referenz-Sputterquelle, welche der Schlüsselquelle der mindestens einen Sputterquelle (3.1) entspricht, benötigen, um vom Referenz-Sputtertarget der Referenz-Sputterquelle, welche der Schlüsselquelle der mindestens einen Sputterquelle (3.1) entspricht, zur Substratposition zu gelangen.

15. Abscheidungsvorrichtung nach Anspruch 14, wobei das Steuermodul (6) so ausgelegt ist, dass es auf den in einer Abstimmdatendatei auf einem Datenspeicher (10) gespeicherten Abstimmungsdatensatz (300) zugreifen kann, um den Zeitversatz aus dem Abstimmungsdatensatz (300) zu ermitteln.

## Revendications

1. Procédé de dépôt d'une couche de matériau (101) d'un matériau devant être déposé sur un substrat (100) par pulvérisation magnétron pulsée, en particulier par pulvérisation magnétron à impulsions de haute puissance, dans lequel
a) une pression partielle prédéterminée d'un gaz de traitement est maintenue dans une chambre de dépôt (2),
b) le substrat (100) est disposé dans la chambre de dépôt (2),
c) au moins une source de pulvérisation (3.1, 3.2, 3.3) est disposée dans la chambre de dépôt (2), l'au moins une source de pulvérisation (3.1, 3.2, 3.3) comprenant une cible de pulvérisation (4.1, 4.2, 4.3) étant constituée d'au moins un élément chimique du matériau devant être déposé,
d) des impulsions de tension sont appliquées à l'aide d'au moins une source de tension (5.1, 5.2) à la au moins une source de pulvérisation (3.1, 3.2, 3.3) pour générer un plasma (200) à partir du gaz de traitement afin de pulvériser des atomes, en particulier des atomes ionisés, du matériau cible à partir de la cible de pulvérisation (4.1, 4.2, 4.3) de l'une respective des au moins une source de pulvérisation (3.1, 3.2, 3.3) pour déposer les atomes respectifs sur le substrat (100) afin de déposer la couche de matériau sur le substrat (100),
dans lequel les impulsions de tension appliquées à une source synchronisable parmi les au moins une source de pulvérisation (3.1, 3.2, 3.3) sont appliquées à la source de pulvérisation synchronisable parmi les au moins une source de pulvérisation (3.2, 3.3) retardées par un décalage dans le temps par rapport aux impulsions de tension appliquées à une source de pulvérisation clé parmi les au moins une source de pulvérisation (3.1),
i) dans lequel le décalage dans le temps correspond à un temps nécessaire aux atomes, en particulier aux atomes ionisés, de la cible de pulvérisation (4.1) de la source de pulvérisation clé parmi les au moins une source de pulvérisation (3.1) pour atteindre, depuis la cible de pulvérisation (4.1) de la source de pulvérisation clé parmi les au moins une source de pulvérisation (3.1) jusqu'au substrat (100) après qu'une impulsion de tension a été appliquée à la source de pulvérisation clé parmi les au moins une source de pulvérisation (3.1) pour générer le plasma (200) à partir du gaz de traitement afin de pulvériser des atomes, en particulier des atomes ionisés, du matériau cible à partir de la cible de pulvérisation (4.1) de la source de pulvérisation clé parmi les au moins une source de pulvérisation (3.1), et
ii) dans lequel le décalage dans le temps est plus long que le temps nécessaire à la majorité des ions du gaz de traitement pour se propager depuis le plasma (200) situé dans un voisinage de la source de pulvérisation clé parmi les au moins une source de pulvérisation (3.1) jusqu'au substrat (100) après qu'une impulsion de tension a été appliquée à la source de pulvérisation clé parmi les au moins une source de pulvérisation (3.1) pour générer le plasma (200) à partir du gaz de traitement afin de pulvériser des atomes, en particulier des atomes ionisés, du matériau cible à partir de la cible de pulvérisation (4.1) de la source de pulvérisation clé parmi les au moins une source de pulvérisation (3.1).

2. Procédé selon la revendication 1, dans lequel
le substrat (100) est monté sur un support de substrat (7) dans la chambre de dépôt (2), dans lequel le support de substrat (7) est disposé est disposé de manière flottante sur le plan électronique dans la chambre de dépôt (2).

3. Procédé selon la revendication 1 ou la revendication 2, dans lequel
le décalage dans le temps se situe dans la plage comprise entre 5 µs et 500 µs, en particulier dans la plage comprise entre 5 µs et 100 µs.

4. Procédé selon l'une quelconque des revendications 1 à 3, dans lequel la au moins une source de pulvérisation (3.1, 3.2, 3.3) comprend au moins deux sources de pulvérisation différentes (3.1, 3.2, 3.3), dans lequel des impulsions de tension sont appliquées à partir de la au moins une source de tension (5.1, 5.2) aux au moins deux sources de pulvérisation (3.1, 3.2, 3.3) pour générer un plasma (200) à partir du gaz de traitement afin de pulvériser des atomes, en particulier des atomes ionisés, du matériau cible à partir de la cible de pulvérisation (4.1, 4.2, 4.3) de l'une respective parmi les au moins deux sources de pulvérisation (3.1, 3.2, 3.3) pour déposer les atomes respectifs sur le substrat (100) afin de déposer la couche de matériau (101) sur le substrat (100), dans lequel les impulsions de tension appliquées à la source de pulvérisation synchronisable parmi les au moins deux sources de pulvérisation (3.2, 3.3) sont appliquées à la source de pulvérisation synchronisable parmi les au moins deux sources de pulvérisation (3.2, 3.3) avec un décalage dans le temps par rapport aux impulsions de tension appliquées à la source de pulvérisation clé parmi les au moins deux sources de pulvérisation (3.1).

5. Procédé selon la revendication 4, dans lequel
la source de pulvérisation synchronisable parmi les au moins deux sources de pulvérisation (3.2, 3.3) et la source de pulvérisation clé parmi les au moins deux sources de pulvérisation (3.1) sont des sources de pulvérisation différentes.

6. Procédé selon la revendication 5, dans lequel
la cible de pulvérisation (4.1) de la source de pulvérisation clé parmi les au moins deux sources de pulvérisation (3.1) est constituée d'au moins un élément chimique du matériau devant être déposé qui est plus lourd que chacun des au moins un élément chimique dont est constituée la cible de pulvérisation (4.2, 4.3) de la source de pulvérisation synchronisable parmi les au moins deux sources de pulvérisation (3.2, 3.3).

7. Procédé selon l'une quelconque des revendications 1 à 6, dans lequel
le matériau à partir duquel la couche de matériau (101) est déposée sur le substrat (100) est un matériau piézoélectrique ou un matériau ferroélectrique, en particulier un piézoélectrique de nitrure à base d'AIN ou un matériau ferroélectrique de nitrure à base d'AIN.

8. Procédé selon l'une quelconque des revendications 1 à 6, dans lequel
le matériau à partir duquel la couche de matériau (101) est déposée sur le substrat (100) est un oxyde ferroélectrique, en particulier l'un parmi PbZr/TiO₃, BaTiO₃, PbTiO₃ et BiFeO₃.

9. Procédé selon l'une quelconque des revendications 1 à 6, dans lequel
le matériau à partir duquel la couche de matériau (101) est déposée sur le substrat (100) est un composé électro-conducteur, en particulier l'un parmi TiN, TaN, WN, ZrN, SnO:ln et ZnO:Al.

10. Procédé de génération d'un ensemble de données de réglage (300) pour un appareil de dépôt (1) destiné à déposer une couche de matériau (101) d'un matériau devant être déposé sur un substrat (100) par pulvérisation magnétron pulsée, en particulier par pulvérisation magnétron à impulsions de haute puissance, afin de permettre le dépôt de la couche de matériau (101) du matériau devant être déposé sur le substrat (100) à l'aide de l'appareil de dépôt (1) avec le procédé selon l'une quelconque des revendications 1 à 9, dans lequel l'appareil de dépôt (1) comprend une chambre de dépôt (2), dans lequel, dans le procédé de génération de l'ensemble de données de réglage (300),
a) au moins une source de pulvérisation de référence est disposée à l'intérieur d'une chambre de dépôt de référence d'un appareil de référence du même type que la chambre de dépôt (2) de l'appareil de dépôt (1), la au moins une source de pulvérisation de référence comprenant une cible de pulvérisation de référence étant constituée d'au moins un élément chimique du matériau devant être potentiellement déposé sur un substrat (100) à l'aide de l'appareil de dépôt (1),
b) une pression partielle prédéterminée d'un gaz de traitement est maintenue dans la chambre de dépôt de référence,
c) des impulsions de tension sont appliquées à l'aide d'au moins une source de tension de référence à la au moins une source de pulvérisation de référence pour générer un plasma à partir du gaz de traitement afin de pulvériser des atomes, en particulier des atomes ionisés, du matériau de cible de référence à partir de la cible de pulvérisation de référence de la source de pulvérisation de référence respective parmi les au moins une source de pulvérisation de référence, comme cela est fait pour déposer les atomes respectifs sur un substrat (100) pour déposer une couche de matériau (101) du matériau devant potentiellement être déposé sur le substrat (100) à l'aide de l'appareil de dépôt (1), et
d) on mesure le temps que mettent les atomes, en particulier les atomes ionisés, de la cible de pulvérisation de référence de la au moins une source de pulvérisation de référence pour atteindre, depuis la cible de pulvérisation de référence de la source de pulvérisation de référence respective parmi les au moins une source de pulvérisation de référence, une position du substrat dans la chambre de dépôt de référence, la position du substrat correspondant à une position du substrat (100) dans la chambre de dépôt (2) de l'appareil de dépôt (1) lorsqu'une couche de matériau (101) du matériau devant être potentiellement déposé sur le substrat (100) est effectivement déposée à l'aide de l'appareil de dépôt (1), dans lequel le temps mesuré, lié au matériau de la cible de référence ou au type de source de pulvérisation de référence, est ajouté à l'ensemble de données de réglage (300).

11. Procédé selon la revendication 10, dans lequel
pour déposer une couche de matériau (101) du matériau devant potentiellement être déposé sur le substrat (100) à l'aide de l'appareil de dépôt (1), au moins deux sources de pulvérisation (3.1, 3.2, 3.3) sont nécessaires,
dans lequel chacune des au moins deux sources de pulvérisation (3.1, 3.2, 3.3) comprend une cible de pulvérisation (4.1, 4.2, 4.3) étant constituée d'au moins un élément chimique du matériau devant potentiellement être déposé sur le substrat (100),
dans lequel au moins deux sources de pulvérisation de référence sont disposées de manière simultanée ou consécutive à leur position respective à l'intérieur de la chambre de dépôt de référence, dans lequel, pour chacune des au moins deux sources de pulvérisation de référence, lorsque la source de pulvérisation de référence respective parmi les au moins deux sources de pulvérisation de référence est disposée à l'intérieur de la chambre de dépôt de référence,
- la pression partielle prédéterminée du gaz de traitement est maintenue dans la chambre de dépôt de référence,
- des impulsions de tension sont appliquées à l'aide de la au moins une source de tension de référence à la source de pulvérisation de référence respective parmi les au moins deux sources de pulvérisation de référence pour générer un plasma à partir du gaz de traitement afin de pulvériser des atomes, en particulier des atomes ionisés, du matériau cible à *partir* de la cible de pulvérisation de référence de la source de pulvérisation de référence respective parmi les au moins deux sources de pulvérisation de référence, comme cela est fait pour déposer les atomes respectifs sur un substrat (100) afin de déposer une couche de matériau (101) du matériau devant potentiellement être déposé sur le substrat (100) à l'aide de l'appareil de dépôt (1),
- le temps nécessaire aux atomes, en particulier aux atomes ionisés, de la cible de pulvérisation de référence de l'une respective parmi les au moins deux sources de pulvérisation de référence pour atteindre la position du substrat dans la chambre de dépôt de référence à partir de la cible de pulvérisation de référence de l'une respective parmi les au moins deux sources de pulvérisation de référence est mesuré, dans lequel le temps mesuré, lié au matériau de la cible de référence ou au type de source de pulvérisation de référence, est ajouté à l'ensemble de données de réglage (300).

12. Procédé selon la revendication 10 ou la revendication 11, dans lequel
l'ensemble de données de réglage (300) est stocké dans un fichier de données de réglage sur un support de stockage de données (10).

13. Appareil de dépôt (1) destiné à déposer une couche de matériau (100) d'un matériau devant être déposé sur un substrat (100) par pulvérisation magnétron pulsée, en particulier par pulvérisation magnétron à impulsions de haute puissance, avec le procédé selon l'une quelconque des revendications 1 à 9, dans lequel l'appareil de dépôt (1) comprend
a) une chambre de dépôt (1) destinée à contenir un gaz de traitement à une pression partielle prédéterminée,
b) au moins une source de pulvérisation (3.1, 3.2, 3.3), en particulier au moins deux sources de pulvérisation (3.1, 3.2, 3.3), chacune de la au moins une source de pulvérisation (3.1, 3.2, 3.3) comprenant une cible de pulvérisation (4.1, 4.2, 4.3) étant constituée d'au moins un élément chimique du matériau devant être déposé sur le substrat (100),
c) au moins une source de tension (5.1, 5.2) destinée à appliquer des impulsions de tension à la au moins une source de pulvérisation (3.1, 3.2, 3.3) pour générer un plasma (200) à partir du gaz de traitement lorsque la chambre de dépôt (2) contient la pression partielle prédéterminée du gaz de traitement, afin de pulvériser des atomes, en particulier des atomes ionisés, du matériau cible à partir de la cible de pulvérisation (4.1, 4.2, 4.3) de la source de pulvérisation respective parmi les au moins une source de pulvérisation (3.1, 3.2, 3.3) afin de déposer les atomes respectifs sur le substrat (100) pour déposer la couche de matériau (101) sur le substrat (100),
d) un module de commande (6) adapté pour commander la au moins une source de tension (5.1, 5.2) afin d'appliquer à une source synchronisable parmi la au moins une source de pulvérisation (3.2, 3.3) les impulsions de tension retardées d'un décalage dans le temps par rapport aux impulsions de tension appliquées à une source de pulvérisation clé parmi la au moins une source de pulvérisation (3.1),
i) dans lequel le décalage dans le temps correspond au temps nécessaire aux atomes, en particulier aux atomes ionisés, de la cible de pulvérisation (4.1) de la source de pulvérisation clé parmi les au moins une source de pulvérisation (3.1) pour atteindre, depuis la cible de pulvérisation (4.1) de la source de pulvérisation clé parmi au moins une source de pulvérisation (3.1) jusqu'au substrat (100) après qu'une impulsion de tension a été appliquée à la source de pulvérisation clé parmi au moins une source de pulvérisation (3.1) pour générer le plasma (200) à partir du gaz de traitement afin de pulvériser des atomes, en particulier des atomes ionisés, du matériau cible à partir de la cible de pulvérisation (4.1) de la source de pulvérisation clé parmi les au moins une source de pulvérisation (3.1),
et
ii) dans lequel le décalage dans le temps est plus long que le temps nécessaire à la majorité des ions du gaz de traitement pour atteindre le plasma (200) à une proximité de la source de pulvérisation clé parmi les au moins une source de pulvérisation (3.1) jusqu'au substrat (100) après qu'une impulsion de tension a été appliquée à la source de pulvérisation clé parmi les au moins une source de pulvérisation (3.1) pour générer le plasma (200) à partir du gaz de traitement afin de pulvériser des atomes, en particulier des atomes ionisés, du matériau cible à partir de la cible de pulvérisation (4.1) de la source de pulvérisation clé parmi au moins une source de pulvérisation (3.1).

14. Appareil de dépôt (1) selon la revendication 13, dans lequel
le décalage dans le temps est obtenu à partir d'un ensemble de données de réglage (300) généré par le procédé selon l'une quelconque des revendications 10 à 12, dans lequel le décalage dans le temps correspond au temps mesuré lors de l'exécution du procédé selon l'une quelconque des revendications 10 à 12 pour les atomes, en particulier des atomes ionisés, de la cible de pulvérisation de référence de la source de pulvérisation de référence correspondant à la source de pulvérisation clé parmi les au moins une source de pulvérisation (3.1) nécessaire pour atteindre, depuis la cible de pulvérisation de référence de la source de pulvérisation de référence correspondant à la source de pulvéerisation clé parmi au moins une source de pulvérisation (3.1), la position du substrat.

15. Appareil de dépôt selon la revendication 14, dans lequel
le module de commande (6) est adapté pour accéder à l'ensemble de données de réglage (300) stocké dans un fichier de données de réglage sur un dispositif de stockage de données (10) afin d'obtenir le décalage dans le temps à partir de l'ensemble de données de réglage (300).
